(19) Europäisches Patentamt

European Patent Office

Office européen des brevets

(11) **EP 3 717 920 B1**

(12) **EUROPEAN PATENT SPECIFICATION**

(45) Date of publication and mention of the grant of the patent:
**22.06.2022 Bulletin 2022/25**

(21) Application number: **18815965.1**

(22) Date of filing: **29.11.2018**

(51) International Patent Classification (IPC):
**G01R 33/032** *(2006.01)*      **G01R 33/26** *(2006.01)*

(52) Cooperative Patent Classification (CPC):
**G01R 33/26; G01R 33/032**

(86) International application number:
**PCT/EP2018/083026**

(87) International publication number:
**WO 2019/106098 (06.06.2019 Gazette 2019/23)**

(54) **APPARATUS FOR DETERMINING A MAGNETIC FIELD AND METHOD OF DETERMINING A MAGNETIC FIELD**

VORRICHTUNG ZUR BESTIMMUNG EINES MAGNETFELDES UND VERFAHREN ZUR BESTIMMUNG EINES MAGNETFELDES

APPAREIL POUR DÉTERMINER UN CHAMP MAGNÉTIQUE ET PROCÉDÉ DE DÉTERMINATION D'UN CHAMP MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.11.2017 DE 102017128283**

(43) Date of publication of application:
**07.10.2020 Bulletin 2020/41**

(73) Proprietor: **Artha AG**
**8952 Schlieren (CH)**

(72) Inventors:
• **BETANCOURT, Christopher**
**8952 Schlieren (CH)**
• **PFIFFNER, Peter**
**8952 Schlieren (CH)**

(74) Representative: **Zimmermann & Partner Patentanwälte mbB**
**Postfach 330 920**
**80069 München (DE)**

(56) References cited:
• **JAMES M. HIGBIE ET AL: "Magnetometry with mesospheric sodium", PROCEEDINGS OF THE NATIONAL ACADEMY OF SCIENCES OF THE UNITED STATES OF AMERICA, vol. 108, no. 9, 1 March 2011 (2011-03-01) , pages 3522-3525, XP055557732, US ISSN: 0027-8424, DOI: 10.1073/pnas.1013641108**
• **ALEXANDRE LAURAIN ET AL: "Low-Threshold Bidirectional Air Lasing", PHYSICAL REVIEW LETTERS, vol. 113, no. 25, 17 December 2014 (2014-12-17), XP055557742, US ISSN: 0031-9007, DOI: 10.1103/PhysRevLett.113.253901**
• **I. M. SAVUKOV ET AL: "Tunable Atomic Magnetometer for Detection of Radio-Frequency Magnetic Fields", PHYSICAL REVIEW LETTERS, vol. 95, no. 6, 3 August 2005 (2005-08-03) , XP055558257, US ISSN: 0031-9007, DOI: 10.1103/PhysRevLett.95.063004**
• **SERGEY MITRYUKOVSKIY ET AL: "Backward stimulated radiation from filaments in nitrogen gas and air pumped by circularly polarized 800 nm femtosecond laser pulses", OPTICS EXPRESS, vol. 22, no. 11, 2 June 2014 (2014-06-02), page 12750, XP055558285, US ISSN: 1094-4087, DOI: 10.1364/OE.22.012750**

**Description**

**FIELD**

Embodiments of the present disclosure relate to an optical magnetometer for determining a magnetic field. In particular, embodiments of the present disclosure relate to determining a magnetic field by detecting a light beam passing an optical path within a volume of interest including a medium. Embodiments further relate to methods of determining a magnetic field.

**BACKGROUND**

Sensitive magnetometers are important in a variety of fields from medical applications to mineral exploration to applications in space. In optical magnetometry, optical magnetometers are used to measure properties of an external magnetic field by utilizing the interaction of light with a medium.

Optical magnetometers can use, for example, an atomic vapor enclosed in a vapor cell, wherein the spin of the atoms is prepared by optical pumping. In some optical magnetometers, a radiofrequency field, that is resonant with the Lamor frequency of the atoms, is applied to the atomic vapor such that the optical properties of the atomic vapor are changed, resulting in a change in transmission.

However, the fields of applications for optical magnetometers are often constrained by their inherent construction. Conventional optical magnetometers measure typically only the magnetic field at a particular spot where the sensor is placed, which can be for example a vapor cell. That is to say, conventional optical magnetometers require the placement of the equipment, e.g. the vapor cell, at the site of the measurement. However, the site may not be accessible for the deployment of the equipment. Further, for measuring a larger area, the equipment would have to be moved to each of the individual measuring sites.

For measuring a larger area, an array of sensors with a large number of individual cells may have to be used. However, a large number of individual cells likely increases the cost of an optical magnetometer.

Accordingly, it would be beneficial to provide a better optical magnetometer having e.g. a broader range of applications. Further, it would be beneficial to provide an optical magnetometer that can measure a magnetic field of a larger area. In particular, it would be beneficial if the measurements would be less time consuming and/or less effortful. Furthermore, it would be beneficial to provide an optical magnetometer having a reduced cost.

A method of magnetrometry using atmospheric lasing is described in JAMES M. HIGBIE ET AL: "Magnetometry with mesospheric sodium", PROCEEDINGS OF THE NATIONAL ACADEMY OF SCIENCES OF THE UNITED STATES OF AMERICA, vol. 108, no. 9, 1 March 2011, pages 3522-3525. A further method of so-called air lasing is described in ALEXANDRE LAURAIN ET AL: "Low-Threshold Bidirectionat Air Lasing", PHYSICAL REVIEW LETTERS, vol. 113, no. 25, 17 December 2014.

**SUMMARY**

In light of the above, an optical magnetometer for determining a magnetic field and a method of determining a magnetic field are provided. Further aspects, benefits, and features of the present disclosure are apparent from the description, and the accompanying drawings.

The present invention is defined by the independent claims and advantageous embodiments are described in the dependent claims.

Fields of applications for the present invention can for example include biomedical diagnosis, i.e. magnetoencephalography or magnetocardiography for measuring electrical activity in e.g. the human brain. The present invention may allow measurements without the need to place a plurality of sensors in direct vicinity of the patient around the patients head. In embodiments of the present invention, the active volume of interest, which is describe below in more detail, can be chosen to be as close to the patient as possible, as no interfering equipment is provided between the patients head and the point of measurement. In other words, the distance between the electrical currents generating a magnetic field and the point of measurement can be decreased. With decreased distance, it may be possible to increase the sensitivity. In even further biomedical applications, it may be possible to measure the magnetic field of regions of the patient that have not been accessible yet, due to the restrictions of conventional optical magnetometers. This could provide new fields of biomedical magnetic field imaging.

Fields of applications can further include geological exploration, e.g. for magnetic prospecting. Variations of the magnetic field of the earth can be employed to prospect for e.g. mineral or petroleum resources and deposits. Magnetic exploration typically uses airborne techniques. The resulting magnetic anomaly maps can provide information about geological trends. The magnetic field of the Earth magnetizes rocks to a variable degree which is determined by their magnetic susceptibility, intensity and magnetizing force. Sedimentary rocks, being gas and oil repositories, are most commonly non-magnetic. Accordingly, the present invention can provide an optical magnetometer that can for example remotely scan a geological region of interest to gather information of the magnetic anomaly of the region of interest.

Further applications will be described in the following and will also be apparent from the description of the present invention and the embodiments described therein.

## UNDERLYING PHYSICS AND DESCRIPTION OF AN EMBODIMENT AND VARIANTS THEREOF

So that the manner in which the above recited features of the present disclosure can be understood in detail, a more particular description of an embodiment of the present disclosure, briefly summarized above, is discussed in the following. The accompanying drawings relate to this embodiment of the present disclosure and variants of this embodiment and are described in the following:

Fig. 1 illustrates an energy level diagram of two atomic species according to an embodiment described herein;
Fig. 2 illustrates splitting of a degenerate energy level due to the Zeeman Effect;
Fig. 3 schematically shows an optical magnetometer according to a first embodiment of the present disclosure;
Fig. 4 schematically shows an optical magnetometer according to a second embodiment of the present disclosure;
Fig. 5 schematically shows an optical magnetometer according to a third embodiment of the present disclosure;
Fig. 6 schematically shows an optical magnetometer according to a fourth embodiment of the present disclosure;
Fig. 7 schematically shows an optical magnetometer according to a fifth embodiment of the present disclosure;
Fig. 8 schematically shows an optical magnetometer according to a sixth embodiment of the present disclosure;
Fig. 9 shows a chart illustrating a method of determining a magnetic field according to embodiments described herein;

One object of the present disclosure is to measure a magnetic field, B(t), using the principal of optical magnetometry combined with atmospheric lasing. Atmospheric lasing will be described in detail hereinafter. Atmospheric lasing will be used to simultaneously pump and probe a region of interest and to extract the magnetic field in that region from its effect on polarized light via paramagnetic effects. The change of the properties of light through a medium subject to a magnetic field is referred to as optical activity. Optical activity can manifest itself in optical rotation, which is also referred to as the Faraday Effect, and/or in circular dichroism. The amount of rotation of the plane of polarization of linearly polarized light and amount of attenuation of circularly polarized light can carry information about the strength of the magnetic field in the region of interest. When circular dichroism stems from magnetic field induced effects, it is referred to as magnetic circular dichroism (MCD).

While any medium in the presence of a magnetic field will exhibit optical activity, the effect is usually too small to be measured for weak magnetic fields. However, with optically pumping the medium, a large component in the direction of pumping of the angular momentum J can be created. Through optical pumping, paramagnetic effects can be enhanced. Hereinafter, the optically pumped region is referred to as the active volume or as the volume of interest. It is these enhanced paramagnetic effects that can be measured in optical magnetometry by sending a probe beam through the active volume. The probe beam can be the same as the pump beam, or as more typical, a separate beam altogether.

In conventional optical magnetometers, alkali vapors are used within a small vessel or tube to define an active volume. One object of the present disclosure is to use air as a medium. However, the medium is not limited to air, but the medium may also be a medium of air constituents such as, for example, gaseous oxygen or nitrogen. A further object of the present disclosure is to perform a measurement remotely. That is to say, without the need to place any experimental equipment near the region of interest. Embodiments of the present disclosure provide such a method to perform measurements remotely, where a single laser system can be used for optical pumping, while simultaneously producing a co-propagating beam via air lasing that acts as a probe and is directed back to the source of the pump beam.

Just as it is possible to polarize an alkali medium via optical pumping, i.e. creating a large < J >, optical pumping of air can also lead to a large polarization of the medium.

[Air lasing]

Air lasing, or atmospheric lasing, is, for example, occurring when molecular oxygen or nitrogen is dissociated using UV light, while the dissociation is simultaneously followed by excitation of the atomic states, and subsequently followed by lasing of an IR beam of the dissociated molecules relaxing to a lower state.

In the following, one specific example of an excited state of atomic oxygen and one specific example of an excited state of atomic nitrogen used for air lasing is described. However, air lasing is not limited to the described specific examples of energy levels and different energy levels can be used if the energy levels are suitable to generate an air lasing beam.

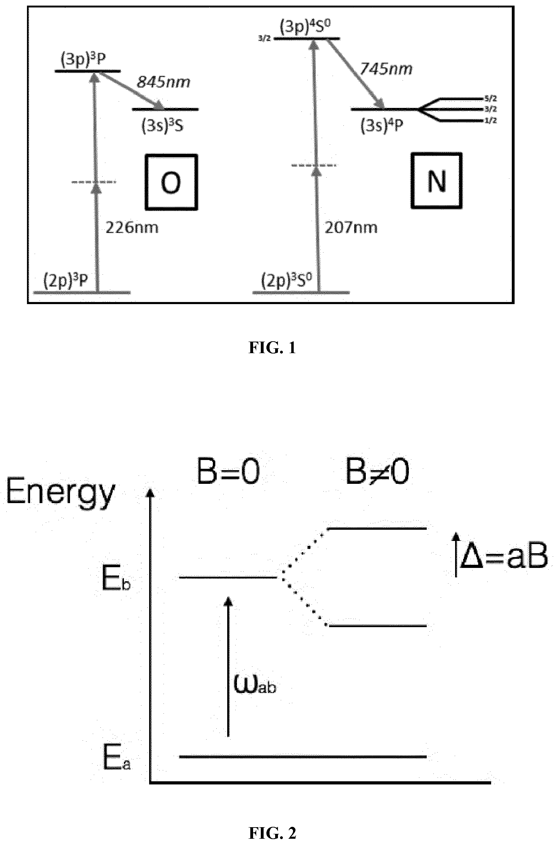

Fig. 1 illustrates two-photon dissociation of molecular oxygen and nitrogen using UV light and two-photon excitation of the atomic states, followed by lasing of an IR beam via coherent stimulated Raman scattering.

The use of air as a medium for an optical magnetometer can be advantageous compared to conventional optical magnetometers. First, the use of air or a vapor as a medium allows for room temperature measurements without the need of additional equipment at the measuring site. This, coupled with atmospheric lasing, allows for remote detection applications at distances ranging from cm to km. It also allows for non-invasive measurements of magnetic fields in biomedical applications. Furthermore, the pump/probe beam can be focused to almost any location desired, allowing for quick scans of a much larger volume.

With air lasing magnetometry it is possible to scan a large area remotely. That is to say, a limited local sensor or array of sensors with a large number of individual cells may not be required. Furthermore, air lasing magnetometry can scan different areas quickly. Another advantage is that it is possible to scan areas with high spatial resolution, even when scanning these areas remotely from larger distances.

One challenge can lie in a fast decoherence rate in both ambient air (the rate between collisions is typically $\gamma \sim 10^5 s^{-1}$) and fast decoherence during atmospheric lasing ($\gamma \sim 10^{10} s^{-1}$). In some alkali vapors, the decoherence time is on the order of seconds. An increase in the decoherence rate may lead to a decrease in sensitivity of a magnetometer. The minimum detectable field can be for example go as $\delta \sim \sqrt{\gamma/N}$ , where N is the density of atoms in the optically pumped ensemble. A fast decoherence in air means that quick measurements, i.e. by continuous re-pumping on short time scales, can lead to more sensitivity. On the other hand, the abundance of molecules in air is several orders of magnitude higher than in typical alkali vapors, which can increase the sensitivity or can at least partially cancel the decreased sensitivity due to decoherence.

In this embodiment of the present disclosure, polarized light, which can be circularly polarized or elliptically polarized, is propagating in a direction, normally referred to as the z-direction. The polarized light is focused to a point. The wavelength and the intensity of the polarized light is chosen such that it simultaneously dissociates a given molecular species in air, such as, for example molecular oxygen or molecular nitrogen, and excites one of the atomic fragments. This excitation is followed by lasing from the excited atomic state via stimulated Raman scattering, as illustrated in Fig. 1. This creates an active cigar shaped region around the focal point of the optically pumped atoms, i.e. the active volume in this case.

[Underlying physics]

[Propagation of light through a medium]

Consider an electromagnetic wave of frequency $\omega$ traveling, i.e. in the $+\hat{z}$ direction, so the electric field follows equation (1)

$$E = E_0 e^{(\tilde{k}z - \omega t)} \tag{1}$$

where $E_0$ is the electric field at z = 0 and $\tilde{k}$ is the complex wave number. The complex wave number is related to the complex index of refraction, $\tilde{n}$, through

$$\tilde{k} = k\tilde{n} \tag{2}$$

where k = $\omega$/c, and c is the speed of light in vacuum. This can be further related to the electric susceptibility, $\chi$, by

$$\tilde{n} = \sqrt{1 + \chi}$$
$$\approx 1 + \chi/2. \tag{3}$$

Here we take $\chi$ to be complex, i.e. $\chi = \chi' + i\chi''$. Inserting equations (2) and (3) into equation (1) gives

$$E = E_0 e^{i[k(1 + \chi'/2)z - \omega t]} e^{-k_0 \chi''/2}. \tag{4}$$

It can be seen from equation (4) that $\chi'$ is responsible for optical rotation, while $\chi''$ is responsible for absorption, or attenuation, of the light beam.

[Susceptibility]

The susceptibility tensor of a medium can be written into several components,

$$\chi = \sum_{i=0}^{n} \chi_i < M_i > \qquad (5)$$

where $M_i$ are the different multipole moments of the medium. Taking $M_0$ to be the unit operator, we can define the equilibrium value of the susceptibility $\chi_{eq} = \chi_0 M_0 = \chi_0$. In the presence of a small magnetic field, the susceptibility gains additional terms

$$\chi = \chi_{eq} + \chi_{hfs} \boldsymbol{I} \cdot \boldsymbol{J} + \sum_{FF'} \chi_{gt}(FF') \boldsymbol{J}(FF') \times + \sum_{FF'} \chi_{bf}(FF') \boldsymbol{Q}(FF') \qquad (6)$$

where $\boldsymbol{I}$, $\boldsymbol{J}$, and $\boldsymbol{Q}$ are the nuclear spin operator, atomic spin operator and quadrupole moment operator, respectively. The second term is the hyperfine structure susceptibility, the third term is the gyrotropic susceptibility which is responsible for paramagnetic effects, and the last term is the befringement susceptibility. In the present case, it is assumed that no population imbalance exists between the *hfs* levels of the ground state, i.e. $< \boldsymbol{I} \cdot \boldsymbol{J} >= 0$, and that the befringement term is negligible. So the susceptibility tensor is

$$\chi = \chi_{eq} + \sum_{FF'} \chi_{gt}(FF') \boldsymbol{J}(FF') \times . \qquad (7)$$

[Circular dichroism of an optically pumped medium]

Consider an optically pumping of a medium, for example, a vapor or a gas with circularly polarized light, such that a large $< \boldsymbol{J} >$ is prepared along the pumping direction. A circularly polarized probe beam of frequency $\omega$ passes through the vapor of length L in a direction that makes an angle $\alpha$ with respect to the pump beam direction. It can be shown via equation $\chi_{gt}''$ (4) that a non-zero term will contribute to the attenuation of the signal an amount of

$$\delta \phi_{gt} = NkL\boldsymbol{s} \cdot < \boldsymbol{J} > \Phi_0 a_{gt}''(\omega) \qquad (8)$$

where N is the density of atoms in the vapor or in the gas, $\Phi_0$ is the incident flux of the probe beam and $\alpha_{gt}''(\omega)$ is the imaginary part of the gyrotropic response function. The average photon spin of the probe beam, s, will be a unit vector pointing along the direction of propagation for circularly polarized light. The function $\alpha_{gt}''$ can be shown to have units of $[m^3]$ from a dimensional analysis.

The structural form of the gyrotropic response function $\alpha_{gt}''(\omega)$ can be inferred by considering the susceptibility for the case where $\omega$ is near resonance with an $a \rightarrow b$ transition. For such a two level transition, the complex part of the susceptibility goes as

$$\chi'' \propto \frac{1}{\Delta^2/\gamma_c^2 + 1} \approx 1 - \Delta^2/\gamma_c^2 \qquad (9)$$

where $\Delta = \omega - \omega_{ab}$ is the laser detuning and $\gamma_c$ is the dephasing, or relaxation, rate. Taking the first, constant term to correspond to the equilibrium value of the susceptibility, we can infer that the gyrotropic response function is

$$a''_{gt}(\omega) = -(1/k^3)\Delta^2/\gamma_c^2 = -(1/k^3)(\omega - \omega_{ab})^2/\gamma_c^2 \tag{10}$$

where the factor of $1/k^3$ has been included to ensure the correct dimensions.

We can now write the final form of the imaginary component of the susceptibility as

$$\chi'' \approx \chi''_{eq} + 2Nk^{-3}L\Phi_0 s \cdot \langle \boldsymbol{J} \rangle \Delta^2/\gamma_c^2 \tag{11}$$

which leads to an attenuation of

$$\phi = -\frac{\omega}{2c}\chi''_{eq} + \frac{c^2}{\omega^2}NL\Phi_0 s \cdot \langle \boldsymbol{J} \rangle \Delta^2/\gamma_c^2$$
$$= -\frac{\omega}{2c}\chi''_{eq} + \frac{c^2}{\omega^2}NL\Phi_0 s \cdot \langle \boldsymbol{J} \rangle a^2 B^2/\gamma_c^2 \tag{12}$$

where we have used assumed that the laser detuning stems from the Zeeman effect, that is $\Delta = aB$, illustrated in Fig. 2, showing an illustration of a degenerate level $E_b$ being split due to the Zeeman effect. Here, $a$ is a factor containing Bohr's magneton, Planck's constant and the gyromagnetic factors of the two levels in question.

[Optical rotation of optically pumped vapors]

We again consider the case of an optically pumped vapor where a large $\langle \boldsymbol{J} \rangle$ is oriented along the pumping direction. A linearly polarized beam of frequency $\omega$ passes through the vapor of length L, again at an angle $\alpha$ with respect to the pump beam direction. The plane of polarization can be shown to rotate by an angle

$$\delta\theta = NkL\hat{\boldsymbol{k}} \cdot \langle \boldsymbol{J} \rangle a'_{gt}(\omega). \tag{13}$$

Again, comparing the form of $\chi'$ for an $a \rightarrow b$ transition

$$\chi' \propto \frac{\Delta}{\Delta^2/\gamma_c^2 + 1} \approx \Delta \tag{14}$$

we find from dimensional analysis

$$a'_{gt} = k^{-3}\Delta/\gamma_c. \tag{15}$$

The amount of rotation becomes

$$\delta\theta = Nk^{-2}L\hat{\boldsymbol{k}} \cdot \langle \boldsymbol{J} \rangle \Delta/\gamma_c$$
$$= \frac{c^2}{\omega^2}NL\hat{\boldsymbol{k}} \cdot \langle \boldsymbol{J} \rangle aB/\gamma_c \tag{16}$$

[Spin alignment]

The interaction of light with the spin and magnetic field can be described by the Hamiltonian

$$H_i = \hbar\gamma_g \boldsymbol{B} \cdot \boldsymbol{J}, \tag{17}$$

The equations of motion are then

$$
\frac{\partial \boldsymbol{J}}{\partial t} = -\frac{i}{\hbar}\left[\boldsymbol{J}, H_i\right]
$$
$$
= \gamma_g \boldsymbol{J} \times \boldsymbol{B}
$$
$$
= \gamma_g \begin{pmatrix} J_y B_z - J_z B_y \\ J_z B_x - J_x B_z \\ J_x B_y - J_y B_x \end{pmatrix}. \tag{18}
$$

We can choose the coordinate system such that $B_x = B_y = B_\perp/\sqrt{2}$ ,in which case we find

$$
\frac{\partial^2}{\partial t^2} J_z = \frac{1}{\sqrt{2}}\left[\gamma_g(J_x - J_y)\frac{\partial}{\partial t}B_\perp + \gamma_g B_\perp\left(\frac{\partial}{\partial t}J_x - \frac{\partial}{\partial t}J_y\right)\right]. \tag{19}
$$

For the case of optical pumping of air via atmospheric lasing, we find a decoherence rate of $\gamma_c \sim 10^{10}$s$^{-1}$. Thus, magnetic fields with frequencies lower that 10 GHz can be treated as constant within this time period, i.e. $\partial B/\partial t \approx 0$. We can then write

$$
\frac{\partial^2}{\partial t^2} J_z \approx \gamma_g^2 B_\perp/\sqrt{2}\left[J_y B_z - J_z B_\perp/\sqrt{2} - J_z B_\perp/\sqrt{2} + J_x B_z\right]
$$
$$
= \gamma_g^2 B_\perp^2 J_z + \gamma_g^2 B_z B_\perp/\sqrt{2}(J_x + J_y) \tag{20}
$$

Now, if we note that optical pumping in the **z**-direction will lead to $J_z \gg J_x, J_y$, then we have a solution

$$
J_z(t) = e^{-\gamma_c t}\left[A_1 \sin(\Omega t) + A_2 \cos(\Omega t)\right] \tag{21}
$$

where a factor of $e^{-\gamma_c t}$ has been added to account for spin decoherence. Furthermore, we note that for weak magnetic fields, that is for **B** << 1 T, then $\Omega \ll \gamma_c$ so we may write

$$
J_z(t) \approx J_z(0)e^{-\gamma_c t}. \tag{22}
$$

[Stokes vector formalism]

The polarization state of light can be described by the Stokes vector

$$
\mathbf{S} = \begin{pmatrix} S_0 \\ S_1 \\ S_2 \\ S_3 \end{pmatrix} = \begin{pmatrix} I \\ Q \\ U \\ V \end{pmatrix} \tag{23}
$$

where $I$ represents the total intensity of the light beam, $Q$ the intensity difference between $x$ and $y$ polarized light, $U$ the intensity difference between $\pm 45°$ polarized light and V is the intensity difference between right- and left-handed polarized light.

In this formalism, the effects of a medium on a light beam can described by a 4 x 4 matrix **M**, called the *Mueller matrix,* which acts on an incoming Stokes vector to produce an outgoing Stokes vector. So if we begin with a light beam characterized by **S**$^i$, then the outgoing beam **S**$^f$ is

$$\mathbf{S}^f = \mathbf{M}\mathbf{S}^i. \tag{24}$$

The Mueller matrix for a medium subject to a magnetic field is given by

$$\mathbf{M} = T \begin{pmatrix} 1+\phi^2 & 0 & 0 & 2\phi \\ 0 & (1-\phi^2)\cos(2\theta) & (1-\phi^2)\sin(2\theta) & 0 \\ 0 & -(1-\phi^2)\sin(2\theta) & (1-\phi^2)\cos(2\theta) & 0 \\ 2\phi & 0 & 0 & 1+\phi^2 \end{pmatrix} \tag{25}$$

where T is the average transmittance of unpolarized light, $\theta$ is the amount of optical rotation and $\phi$ is the amount of circular dichroism.

[Circularly polarized light]

As an input, the normalized Stokes vector for right-handed polarized light is taken,

$$\mathbf{S}^i = \begin{pmatrix} 1 \\ 0 \\ 0 \\ 1 \end{pmatrix}. \tag{26}$$

The last element is +1 for right-handed circularly polarized light and -1 for left-handed circularly polarized light. The outgoing Stokes vector becomes

$$\mathbf{S}^f = T \begin{pmatrix} 1+2\phi+\phi^2 \\ 0 \\ 0 \\ 1+2\phi+\phi^2 \end{pmatrix}. \tag{27}$$

The intensity of the light beam after passing through the active volume is then

$$I = T(1+2\phi) \tag{28}$$

where terms $\propto \phi^2$ are dropped, which can be justified if $\phi$ is small. Further, $\phi$ can be broken up into an equilibrium value corresponding to natural circular dichroism of the medium and a time dependent magnetic circular dichroism component due to the influence of a magnetic field $B(t)$, in which case the intensity after the medium reads

$$I = T[1 + 2\phi_{eq} + 2\phi_m(t)], \tag{29}$$

where $\phi_{eq}$ is the equilibrium term, i.e. the natural CD, while $\phi_m$ the term arising from the magnetic field, i.e. the MCD term. Thus, the natural CD signal can be thought of as a baseline to our time dependent MCD signal.

[Linearly polarized light]

Next, the case of linearly polarized light in the x-direction is considered. The normalized Stokes vector in such a case reads

$$\mathbf{S}^i = \begin{pmatrix} 1 \\ 1 \\ 0 \\ 0 \end{pmatrix}. \tag{30}$$

This results in an outgoing vector

$$\mathbf{S}^f = T \begin{pmatrix} 1 + \phi^2 \\ (1 - \phi^2)\cos(2\theta) \\ -(1 - \phi^2)\sin(2\theta) \\ 2\phi \end{pmatrix}, \tag{31}$$

so that linearly polarized light becomes elliptically polarized. Again, if both $\theta$ and $\phi$ are small, then the U component can be written as

$$U = -2T\theta \tag{32}$$

This expression indicates that for small absorption and rotation, each effect may be treated separately, and the plane of polarization is rotated by an amount of $2\theta$. Similar to the case of CD, the rotation angle $\theta$ can be broken up into an equilibrium term and a term arising from the magnetic field, so

$$U = -T\left[2\theta_{eq} + 2\theta_m(t)\right] \tag{33}$$

where $\theta_{eq}$ and $\theta_m$ is the equilibrium term and magnetic field induced term, respectively.

[Elliptically polarized light]

Next, the case of elliptically polarized light is considered. Here, light that has equal amounts of linear and circular components is considered, such that the Stokes vector reads

$$\mathbf{S}^i = \begin{pmatrix} \sqrt{2} \\ 1 \\ 0 \\ 1 \end{pmatrix}. \tag{34}$$

The normalization $I = \sqrt{2}$ is chosen for simplicity. It is further noted, that any general form of elliptically polarized light could have been chosen. Here, the chosen initial state is used just for simplicity.

After passing through the active medium, the Stokes vector reads

$$\mathbf{S}^f = T \begin{pmatrix} (1 + \phi^2)\sqrt{2} + 2\phi \\ (1 - \phi^2)\cos(2\theta) \\ -(1 - \phi^2)\sin(2\theta) \\ 1 + 2\sqrt{2}\phi + \phi^2 \end{pmatrix}. \tag{35}$$

Again, when considering the case where both $\theta$ and $\phi$ are small, the final intensity reads

$$I = T\left[\sqrt{2} + 2\phi_{eq} + 2\phi_m(t)\right]. \tag{36}$$

This is equivalent to equation (29). The factor of $\sqrt{2}$ is arbitrary and corresponds to the chosen normalization of the initial intensity, which is just modified by additive term $2\phi$, similar to above. Likewise, the final beam can be written as

$$U = -T\left[2\theta_{eq} + 2\theta_m(t)\right] \tag{37}$$

which again is equivalent to equation (33). Note both the absorption and rotation are separated into equilibrium and magnetically induced components as before.

[The backward propagating beam]

The backward propagating beam induced by lasing can contain information of the amount of optical rotation and/or circular dichroism in the active volume, and can be hence used to extract the magnetic field in question.

First, it is noted that the amount of absorbed light of the pump beam with lead to an increase in the intensity of the backward propagating beam. The intensity of the backward beam, $I_b$, to second order in the amount of absorbed pump beam, can be written as

$$I_b(t) = a_0 + a_1 I_A(t) + a_2 I_A^2(t) + h.c. \tag{38}$$

where

$$I_A = I_p^i - I_p^f, \tag{39}$$

and $I_p^i$, $I_p^f$ is the intensity of the pump beam before and after passing through the region of interest, respectively. Using equation (29), the change of absorption for circularly polarized light can thus be written as

$$\delta I_A(t) = -2T\delta\phi(t). \tag{40}$$

This leads to a change of intensity of the backward beam by an amount

$$\begin{aligned}
\delta I_b(t) &= \delta I_A(t)\left[a_1 + 2a_2 I_A(t)\right] \\
&= -\beta(t)2T\delta\phi(t) \\
&= \beta(t)\delta\phi(t) \\
&= \beta(t)B(t)^2.
\end{aligned} \tag{41}$$

In the last equation (41), all pre-factors not depending on the magnetic field B(t) are incorporated into the term $\beta(t)$.

For the case of oxygen, the polarization of the backward propagating beam is always the same as the incoming pump beam, while for nitrogen there is some variability depending on the particular transition being pumped due to the complex fine structure of nitrogen. In the presence of a magnetic field, the plane of polarization will rotate in the region of interest, with the amount of rotation being proportional to the strength of the magnetic field. Thus, measuring the rotation of the plane of polarization of the backward propagating beam with respect to the incoming pump beam will yield information about magnetic field.

By using equation (37), it can be shown that the amount of optical rotation of the backward beam (for elliptically or linearly polarized light) leads to

$$U_b^f = f(t)\left[1 + B(t)\right] \tag{42}$$
,

where the function $f(t)$ contains the initial pump beam intensity, transmittance of the sample, and other terms in equation (16).

[Description of an embodiment]

In the following, an embodiment according to the present disclosure will be described, which makes use of atmospheric lasing. Further variations of this embodiment will be presented in the following section, but more embodiments are possible that make use of the same underlying physics. Even further embodiments will be described in a later section.

[Embodiment 1]

In Embodiment 1, a single laser beam, circularly polarized and having a frequency that is chosen to induce atmospheric lasing is used.

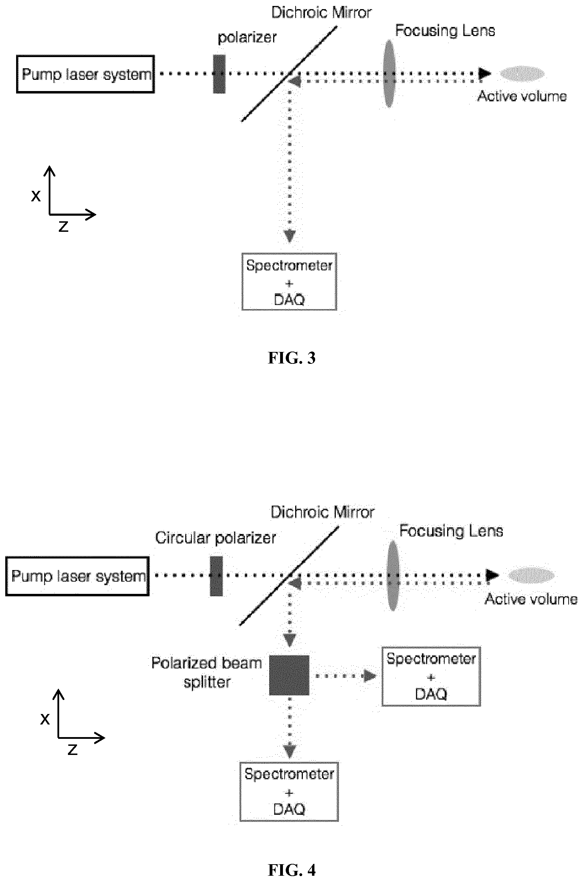

Fig. 3 schematically shows an optical magnetometer which uses air lasing. An initial circularly polarized pump laser sent is focused to a given region under the influence of a magnetic field. This simultaneously creates a large < J > while seeding a backward propagating beam in that same region via atmospheric lasing. The intensity of the backward beam is then monitored with a photosensor, which is connected to a data acquisition system DAQ for further analysis.

[Implementation of Embodiment 1]

- Laser System: A laser system comprising one or more lasers mixed in such a way to produce light at the wavelengths and energy per pulse sufficiently high to produce lasing in air. For example, an output of $\lambda$ = 226 nm for oxygen lasing, 10 mJ per pulse with 10 ns pulse duration. The output of this laser will be referred to as the pump beam. The laser system is used as the laser source generating the pumping laser pulse.

- Polarizer: A polarizer creates a polarized light beam from a non-polarized beam

- Dichroic Mirror: A Dichroic mirror separates the pump beam from the backward propagating beam. The transmission wavelength depends on whether the pump or backward propagating beam should be reflected. In Fig. 3, the pump beam is transmitted through the dichroic mirror. The backward propagating beam is reflected.

- Convex Lens: A convex lens focuses the pump beam to a small volume where the measurement of the magnetic field is performed.

- External Magnet: A magnet capable of generating a constant bias field in the region where the pump beam is focused. The external magnet can be, for example, a solenoid magnet or ferromagnet. The external magnet can be used for a calibration run, as described later.

- Spectrometer and DAQ System: A spectrometer and data acquisition system (DAQ system) collect and analyze the intensities of the different polarized signals of the backward propagating beam. According to this embodiment, outside light filters, photosensors and suitable electronics (oscilloscope or other signal analyzer, PC, cables, suitable software, etc.) are included. The spectrometer and data acquisition system will be used as the detector and evaluation unit, respectively.

[Operating the optical magnetometer of Embodiment 1]

A measurement of a given magnetic field is broken into two parts, a calibration run to determine the pre-factor $\beta(t)$ in equation (41), and a measurement run where the given magnetic field is measured.

[Calibration run]

1. A volume of interest is defined to perform the measurement. Ideally, this is the same region where the final measurement is to be performed. However, some variations can be possible, for example, if the region of interest is hundreds of meters to km away.

2. The laser system, the convex lens, the polarizer and the dichroic mirror are prepared in such a way, as to focus a circularly polarized pump beam to the region of interest, while allowing the transmission of the backward propagating beam back to the position of the DAQ system. For example, one can orient the pump laser to reflect off of a dichroic mirror toward the volume of interest, prepare the polarization of the pump beam after this reflection using a polarizer. Then the convex lens is focusing the resulting polarized pump beam to the region of interest. Finally, the backward beam is transmitted back through the dichroic mirror.

3. A known magnetic field is applied to the region of interest.

4. The pump laser is turned on to optically pump the volume of interest. The intensity of the backward propagating beam is measured with the spectrometer and DAQ system.

5. The $\beta(t)$ term from the measured intensity and the known calibration field is extracted according to equation (41).

[Measurement run]

1. A volume of interest for measuring a magnetic field is defined. Ideally, this is the same region as in the calibration run, although not necessarily as described above.

2. The system is arranged in the same way as in step 2 of the calibration run.

3. The pump laser is turned on to optically pump the relevant volume and measure the intensity of the backward propagating beam with the spectrometer and DAQ system.

4. The magnetic field is extracted according to equation (41).

[Possible modifications of Embodiment 1]

In the following, some possible modifications to the apparatus according to the Embodiment 1 are described.

1. Materials - The materials needed are not limited to those listed here. Additional components may be needed depending on the particular application.

2. Pump laser - The wavelength, energy, pulse duration of the light coming from pump laser and backward propagating beam is not restricted to the wavelengths, energies and pulse durations mentioned here, there may be other suitable configurations suitable for lasing. The molecular dissociation and atomic excitations are not limited to one laser or laser system.

3. Molecular species - The molecular species used for lasing is not restricted to $O_2$ and $N_2$. Any molecular or atomic species where lasing is possible can be used, depending on the application and sensitivity needed. Indeed, although the present disclosure emphasizes on atmospheric lasing, lasing in other gases, fluids, or solids could be possible.

4. Focusing of the pump laser - Focusing of the pump laser is not restricted to focusing from a convex lens. For example for remote detection kilometers away, focusing of the beam may be possible through atmospheric effects or self induced changes of the index of refraction of the atmosphere. For example, Kerr-induced self-focusing could be used to focus the pump laser.

5. The DAQ system - The data acquisition system mentioned is not limited by the components listed here. It may include further light filters, electronics and data analysis software tools. This included any further processing of the measured data and extraction of relevant quantities.

6. The measured magnetic field - The measurement and subsequent data analysis are not restricted to the measured magnetic field, but also investigate any magnetic field derived quantities i.e. the characteristic frequency of the field, the spatial and temporal evolution or any other derived quantities.

7. The measurement volume - The measurement volume is not restricted to a signal position. One or more laser or laser systems may be used to probe one or more volumes simultaneously. The position of the volume or volumes is not required constant in time, depending on the particular application.

8. Calibration run - A calibration run might not always be necessary or desired, depending on the required sensitivity and particular measurement quantity.

## DESCRIPTION OF POSSIBLE VARIANTS

Generally, only the differences with respect to the above described Embodiment 1 are described. Each example is provided by way of explanation of the disclosure and is not meant as a limitation of the disclosure. Further, features illustrated or described as part of one embodiment can be used on or in conjunction with other embodiments to yield yet a further embodiment, provided that the further embodiment falls within the scope of the appended claims.

[Embodiment 2]

In the Embodiment 2, the pump beam is elliptically polarized. This provides a way to optically pump the region of interest, while simultaneously measuring the total intensity and/or the rotation of the plane of polarization of the backward propagating beam. In order to measure the optical rotation of the backward beam, a polarizing beam splitter is used to separate the different polarization components before being sent to the spectrometer and DAQ system.

Fig. 4 schematically shows an optical magnetometer using atmospheric lasing according to the Embodiment 2. An initial elliptically polarized pump laser is focused to a given region. This simultaneously creates a large < J > while seeding a backward propagating beam in that same region via atmospheric lasing. A polarized beam splitter splits the backward beam into separate components. The intensity and amount of optical rotation of the backward beam is then monitored with photosensors.

[Implementation of Embodiment 2]

The implementation of Embodiment 2 is similar to the implementation of Embodiment 1 and only the differences are described in the following.

- Polarized Beam Splitter: A polarized beam splitter PBS separates the different polarization components of the backward propagating beam.

- Spectrometer and DAQ System - A spectrometer and data acquisition system collects and analyzes the intensities of the different polarized signals of the backward propagating beam. According to this embodiment, outside light filters, photosensors and suitable electronics (oscilloscope or other signal analyzer, PC, cables, suitable software, etc.) are included.

[Operating the optical magnetometer of Embodiment 2]

Measurement of a given magnetic field is broken into two parts, a calibration run to determine the pre-factors $\beta(t)$ and $f(t)$ of equations (41) and (42), and a measurement run where the given magnetic field is measured.

[Calibration run]

1. A volume of interest is defined to perform the measurement. Ideally, this is the same region where the final measurement is to be performed. However, some variations can be possible, for example, if the region of interest is hundreds of meters to km away.

2. The laser system, the convex lens, the polarizer and the dichroic mirror are prepared in such a way, as to focus an elliptically polarized pump beam to the region of interest while allowing for transmission of the backward propagating beam back to the position of the DAQ system. For example, one can orient the pump laser to reflect off of a dichroic mirror toward the volume of interest, prepare the polarization of the pump beam after this reflection using a polarizer, then the convex lens will focus the resulting polarized pump beam to the region of interest. Finally, the backward beam should be transmitted back through the dichroic mirror.

3. A known magnetic field is applied to the region of interest.

4. The pump laser is turned on to optically pump the volume of interest. The total intensity and separate polarization components of the backward propagating beam are measured with the spectrometer and DAQ system.

5. The $\beta(t)$ and $f(t)$ terms are extracted from the measurement and the known calibration field according to equation (41) and equation (42), respectively.

[Measurement run]

1. A volume of interest for measuring a magnetic field is defined. Ideally, this is the same region as in the calibration run, although not necessarily as described above.

2. The system is arranged in the same way as in step 2 of the calibration run.

3. The pump laser is turned on to optically pump the volume of interest and measure the total intensity and separate polarization components of the backward propagating beam with the spectrometer and DAQ system.

4. The magnetic field is extracted according to equation (41) and/or equation (42).

[Possible modifications of Embodiment 2]

In the following, some possible modifications to the apparatus according to the Embodiment 2 are described.

1. Materials - The materials needed are not limited to those listed here. Additional components may be needed depending on the particular application.

2. Pump laser - The wavelength, energy, pulse duration of the light coming from pump laser and backward propagating beam is not restricted to the wavelengths, energies and pulse durations mentioned here, there may be other suitable configurations suitable for lasing. The molecular dissociation and atomic excitations are not limited to one laser or laser system.

3. Molecular species - The molecular species used for lasing is not restricted to $O_2$ and $N_2$. Any molecular or atomic species where lasing is possible can be used, depending on the application and sensitivity needed. Indeed, although the present disclosure emphasizes on atmospheric lasing, lasing in other gases or fluids could be possible.

4. Focusing of the pump laser - Focusing of the pump laser is not restricted to focusing from a convex lens. For example for remote detection kilometers away, self focusing of the beam may be possible through atmospheric effects or self induced changes of the index of refraction of the atmosphere. For example, Kerr-induced self-focusing could be used to focus the pump laser

5. The DAQ system - The data acquisition system mentioned is not limited by the components listed here. It may include further light filters, electronics and data analysis software tools. This included any further processing of the measured data and extraction of relevant quantities.

6. The measured magnetic field - The measurement and subsequent data analysis are not restricted to the measured magnetic field, but also investigate any magnetic field derived quantities i.e. the characteristic frequency of the field, the spatial and temporal evolution or any other derived quantities.

7. The measurement volume - The measurement volume is not restricted to a signal position. One or more laser or laser systems may be used to probe one or more volumes simultaneously. The position of the volume or volumes is not required constant in time, depending on the particular application.

8. Calibration run - A calibration run might not always be necessary or desired, depending on the required sensitivity and particular measurement quantity.

[Embodiment 3]

In the Embodiment 3, two laser beams are focused to the same volume. One beam is used to optically pump the vapor and is circularly polarized, while the other is linearly polarized and used as a probe. Similar to the Embodiment 2, this provides a way to optically pump the region of interest, while simultaneously measuring the total intensity and/or the rotation of the plane of polarization of the backward propagating beam. For measuring the optical rotation of the backward beam, a polarized beam splitter is used to separate the different polarization components before being sent to the spectrometer and DAQ system.

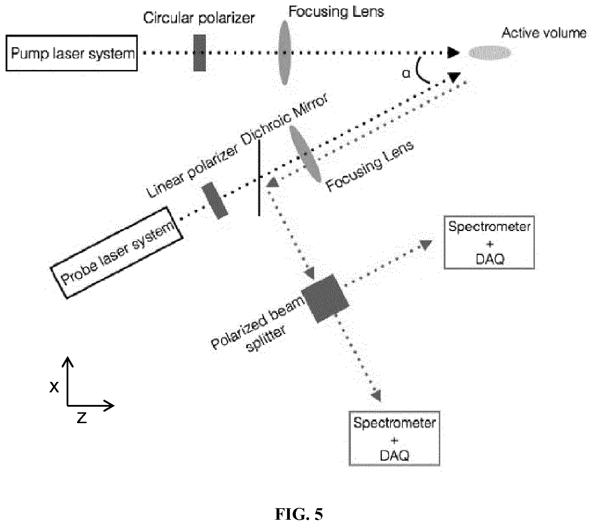

Fig. 5 schematically shows an atmospheric lasing optical magnetometer according to the Embodiment 3. An initial circularly polarized pump laser is focused to a given region, which creates a large < J > . Simultaneously, a separate laser beam that is linearly polarized is focused to the same region and generates a backward beam. A polarized beam splitter splits the backward beam into separate components. The intensity and amount of optical rotation of the backward beam is then monitored with photosensors.

[Implementation of Embodiment 3]

Again, only the differences with respect to the above described Embodiment 1 are described.

- Probe Laser System - A laser system comprising one or more lasers mixed in such a way to produce light at the wavelengths and energy per pulse sufficiently high to produce lasing in air , i.e. output of A = 226 nm for oxygen lasing, 10 mJ per pulse with 10 ns pulse duration. The output of this laser will be referred to as the pump beam. The probe and pump laser system can also be one and the same.

- Polarizers - Polarizers create a polarized light beam from a non-polarized beam.

- Dichroic Mirror - A Dichroic mirror separates the pump beam from the backward propagating beam. The transmission wavelength depends on whether the pump or backward propagating beam should be reflected.

- Convex Lenses - Convex lenses focus the pump and probe beam to a small volume where we would like to measure the magnetic field.

- Polarized Beam Splitter - A polarized beam splitter separates the different polarization components of the backward propagating beam.

- Spectrometer and DAQ System - A spectrometer and data acquisition system (DAQ system) collect and analyze the intensities of the different polarized signals of the backward propagating beam. According to this embodiment, outside light filters, photosensors and suitable electronics (oscilloscope or other signal analyzer, PC, cables, suitable software, etc.) are included

[Operating the optical magnetometer of Embodiment 3]

Measurement of a given magnetic field is broken into two parts, a calibration run to determine the pre-factor $f(t)$ in equation (42), and a measurement run where a given magnetic field is measured.

[Calibration run]

1. A volume of interest is defined to perform the measurement. Ideally, this is the same region where the final measurement is to be performed. However, some variations can be possible, for example, if the region of interest is hundreds of meters to km away.

2. The pump laser system, convex lens and polarizer are prepared in such a way, as to focus a circularly polarized pump beam to the region of interest.

3. The probe laser system, convex lens, polarizer and dichroic mirror are prepared in such a way, as to focus a circularly polarized pump beam to the region of interest while allowing for transmission of the backward propagating beam back to the position of the DAQ system. The probe beam can be angled by an angle $\alpha$ with respect to the pumping direction.

4. A known magnetic field is applied to the region of interest

5. The pump laser is turned on to optically pump the volume of interest. The probe laser measures the separate polarization components of the backward propagating beam with the spectrometer and DAQ system. Both pump and probe beams can be applied to the region of interest simultaneously due to the fast decoherence time associated with atmospheric lasing.

6. Extract the $f(t)$ term is extracted from the measurement and the known calibration field according to equation (42) respectively.

[Measurement run]

1. A volume of interest for measuring a magnetic field is defined. Ideally, this is the same region as in the calibration run, although not necessarily as described above.

2. The system is arranged in the same way as in step 2 and step 3 of the calibration run.

3. The pump laser is turned on to optically pump the volume of interest and your probe laser measure the separate polarization components of the backward propagating beam with the spectrometer + DAQ system. Both pump and probe beams can be applied to the region of interest simultaneously due to the fast decoherence time associated with atmospheric lasing.

4. The magnetic field according to equation (42) is extracted.

[Possible modifications of Embodiment 3

In the following, some possible modifications to the apparatus according to the Embodiment 3 are described.

1. Materials - The materials needed are not limited to those listed here. Additional components may be needed depending on the particular application.

2. Pump laser - The wavelength, energy, pulse duration of the light coming from pump laser and backward propagating beam is not restricted to the wavelengths, energies and pulse durations mentioned here, there may be other suitable configurations suitable for lasing. The molecular dissociation and atomic excitations are not limited to one laser or laser system.

3. Molecular species - The molecular species used for lasing is not restricted to $O_2$ and $N_2$. Any molecular or atomic species where lasing is possible can be used, depending on the application and sensitivity needed. Indeed, although the present disclosure emphasizes on atmospheric lasing, lasing in other gases or fluids could be possible.

4. Focusing of the pump and prober lasers - Focusing of the pump/probe laser is not restricted to focusing from a convex lens. For example for remote detection kilometers away, self focusing of the beam may be possible through atmospheric effects or self induced changes of the index of refraction of the atmosphere.

5. The DAQ system - The data acquisition system mentioned is not limited by the components listed here. It may include further light filters, electronics and data analysis software tools. This included any further processing of the measured data and extraction of relevant quantities.

6. The measured magnetic field - The measurement and subsequent data analysis are not restricted to the measured magnetic field, but also investigate any magnetic field derived quantities i.e. the characteristic frequency of the field, the spatial and temporal evolution or any other derived quantities.

7. The measurement volume - The measurement volume is not restricted to a signal position. One or more laser or laser systems may be used to probe one or more volumes simultaneously. The position of the volume or volumes is not required constant in time, depending on the particular application.

8. Calibration run - A calibration run might not always be necessary or desired, depending on the required sensitivity and particular measurement quantity.

9. Measurement of MCD signal - The last option provides a way to also measure the difference in right- and left-handed components of the final backward propagating beam. In such a case, the MCD signal will be the difference in the absorption of the right- and left-handed components. This can increase the sensitivity of such a device, since the MCD signal will now be $\propto B(t)$ instead of $(B(t))^2$, which might be desirable for measuring very small magnetic fields.

**GENERAL ASPECTS AND DETAILED DESCRIPTION OF FURTHER EMBODIMENTS**

General aspects of the present disclosure will now be discussed. Reference will be made in detail to further embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment, provided that the further embodiment falls within the scope of the appended claims.

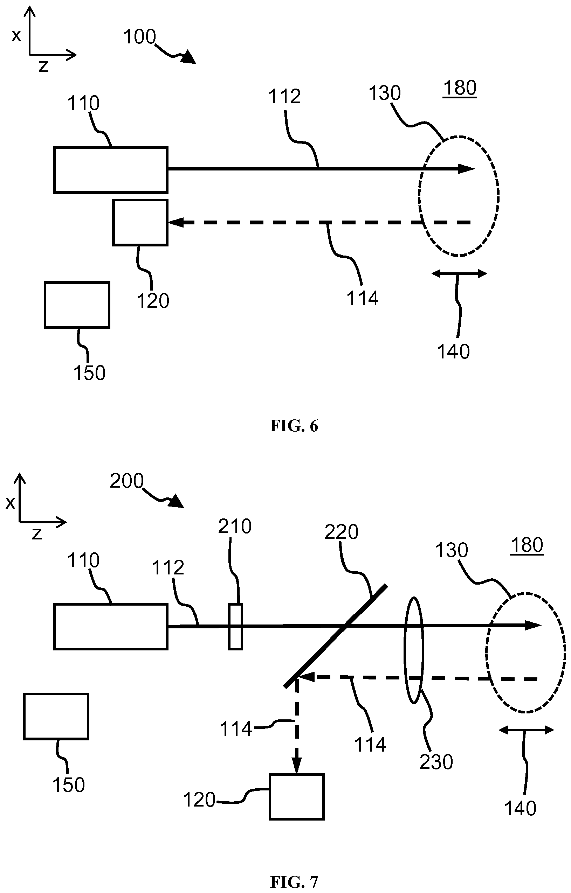

Fig. 6 schematically shows an optical magnetometer 100 according to embodiments described herein.

According to embodiments of the present disclosure, the optical magnetometer 100 determines a magnetic field permeating a volume of interest 130 including a medium. The volume of interest 130 can be, for example, a volume in air or a volume of air. For example, the volume of interest 130 can be in fluid communication with an outer volume 180 enclosing the volume of interest 130, as shown in Fig. 6. The outer volume 180 can be, for example, a volume of the atmosphere. That is to say, the medium inside the volume of interest 130 and the outer volume 180 can be substantially the same.

The volume size of the volume of interest typically depends on the distance between the laser source and the volume of interest to be measured. As described above, the volume of interest to be measured can be described as the active volume, i.e. the optically pumped region. For example, at a distance of about 10cm, the volume to be measure can have a volume size of about $0.3 \text{ mm}^3$. At a distance of about 1km, the volume to be measured may have a volume of about $3 \text{ cm}^3$.

In some embodiments, the volume of interest may be inside a volume of a vessel, e.g. a vessel filled with a fluid such as a gas or a liquid. For example, the vessel could be a vapor cell. In some embodiments, the vessel or the vapor cell is filled with a gas. The gas can be, for example, Oxygen or Nitrogen. The vessel is typically translucent. The term "*a volume of interest"*, as used herein, is not restricted to a volume that is confined by a physical boundary, e.g. a volume confined by the walls of a vessel.

According to embodiments described herein, the volume of interest can include a medium including an atomic species. The term *"atomic species"*, as described herein, can be understood as an atomic element, i.e. a single atom, a molecular species of two or more identical atomic elements, or as a chemical compound composed of at least two different atomic elements. In some embodiments, the atomic species is a molecular species such as, for example, $O_2$ or $N_2$. In further embodiments, the volume of interest includes a medium comprising a molecular species, such as $O_2$ and/or $N_2$, and atomic constituents of the molecular species such as, for example, atomic oxygen O and/or atomic nitrogen N.

According to embodiments described herein, the magnetic field is determined by detecting a light beam passing an optical path within the volume of interest. In Fig. 6, the optical path within the volume of interest 130 is depicted by reference numeral 140. In particular, the optical path may relate to a distance that is covered by a light beam traveling through a portion of the volume of interest 130.

When a light beam travels through a portion of the volume of interest, e.g. as depicted in Fig. 6 by reference numeral 140, the medium may interact with the light beam. In particular, the interaction can depend on the optical activity of the medium. The optical activity of the medium may be influenced by a magnetic field interacting with the medium. A light beam that has traveled through the portion of the volume of interest can carry information of the magnetic field.

According to embodiments described herein, the optical magnetometer 100 includes a laser source 110. The laser source 110 may include one or more lasers. For example, more than one laser can be mixed in the laser source 110 to generate light at a specific wavelength and/or a specific energy per pulse length. The laser source 110 is typically configured to generate a pumping laser pulse.

The term *"pumping"*, as used herein, refers to raising an atomic species to a higher electronic state (energy level) and in particular to optical pumping. In particular, optical pumping of a medium, such as e.g. an active laser medium, can lead to population inversion. The upper electronic state is typically associated to relaxation from the upper electronic state to a lower electronic state. For instance, the laser source can include one or more laser types selected from the group including a dye laser, a mixture of dye lasers, a solid state laser, a gas laser, a chemical laser or a semiconductor laser. In some embodiments, the laser source includes a Ti-sapphire-laser. In embodiments, an optical parametric oscillator can be used to convert an input laser wave into an output laser wave with lower frequency.

In Fig. 6, a pumping laser pulse 112 is directed to the volume of interest 130. The pumping laser pulse 112 has a wavelength tuned for pumping the atomic species to an upper electronic state. The laser source 110 generates the pumping laser pulse 112 at a wavelength that is suitable to excite the atomic species to the upper electronic state.

In some embodiments, a lens system is arranged between the laser source 110 and the volume of interest 130. The lens system is typically configured to direct the pumping laser pulse 112 to a focal point within the volume of interest 130. The lens system typically includes one or more lenses, such as convex lenses or a combination of convex and concave lenses. In some embodiments, the lens system may be comprised by the laser source.

According to embodiments described herein, the pumping laser pulse is configured to polarize at least a fraction of the atomic species. In some embodiments, a polarized pumping laser pulse is generated by the laser source 110. The polarized pumping laser pulse may be elliptically polarized.

In some embodiments, the pumping laser pulse may be substantially circularly polarized. For example, the pumping laser pulse can be right-handed circularly polarized or left-handed circularly polarized. In some embodiments, the polarized pumping laser is elliptically polarized.

In the present disclosure, polarization of at least a fraction of the atomic species is performed by the pumping laser pulse transferring angular momentum to the fraction of the atomic species along the direction of pumping. An ensemble of the atomic species can be spin-polarized along a prescribed direction.

According to embodiments described herein, the magnetometer includes a detector 120 that is configured to detect a light beam characterizing quantity of the light beam 114 passing the optical path 140 within the volume of interest 130, as exemplarily shown in Fig. 1.

The light beam characterizing quantity can be, for example, an intensity, a polarization, a polarization angle, and/or a difference in intensity of different polarization components of the detected light beam. In particular, the light beam characterizing quantity is typically related to the interaction of the light beam with the medium permeated by the magnetic field.

The light beam 114 is generated upon relaxation of the excited atomic species in the upper electronic state to a lower electronic state of the atomic species in the volume of interest. The light beam 114 can be described as a backward propagating beam. The backward propagating beam travels in the opposite direction of the pumping laser pulse 112. The backward propagating beam can typically have a different wavelength than the pumping laser pulse 112.

According to embodiments described herein, the magnetometer includes an evaluation unit 150. The evaluation unit 150 is configured to evaluate a magnetic field characterizing quantity of the magnetic field permeating the volume of interest 130. The magnetic field characterizing quantity is evaluated based on the detected light beam characterizing quantity detected by the detector 120.

The evaluation unit can include components such as a computer, a signal analyzer, an input unit, and an output unit. The evaluation unit can receive from the detector the detected signal, e.g. the detected light beam characterizing quantity. The evaluation unit can be connected with the detector to receive the detected signal. For example, the evaluation unit can be connected to the detector by a data line, such as, e.g. a data cable, a wireless connection or the like.

The evaluation unit typically includes means to calculate the magnetic field characterizing quantity, such as processors, non-volatile storage, and volatile storage. The evaluation unit can for example store program instructions to execute calculations based on the formulas described herein.

According to embodiments described herein, the magnetic field characterizing quantity can be a magnetic field strength, a magnetic field direction, a frequency of the magnetic field, a time-dependency of the magnetic field strength, and/or a time-dependency of the magnetic field direction.

In some embodiments, the magnetic field to be measured can be measured by detection of a polarization rotation of a light beam passing an optical path within the volume of interest. The initial polarization of a light beam can change when passing the optical path within the volume of interest due to the polarization rotation.

According to embodiments described herein that can be combined with embodiments of the present disclosure, the optical magnetometer can include an optical system arranged between the laser source and the volume of interest. The optical system is typically configured to polarize the beam emitted from the laser source into a polarized beam. For example, the optical system can include a polarizer that lets electromagnetic radiation of a specific polarization pass and blocks electromagnetic radiation of other polarizations. In particular, the polarizer may be a circular polarizer to create right-handed circularly polarized light or left-handed circularly polarized light. In some embodiments, the polarizer is configured to transmit elliptically polarized light.

According to embodiments of the present disclosure, the optical system can be arranged within an optical path between the laser source and the volume of interest.

In some embodiments, the laser source is configured to generate an emitted optical radiation such that self-focusing of the optical radiation is induced by atmospheric effects or self-induced changes of the index of refraction of the atmosphere. With self-focusing, the emitted optical radiation can be focused into the volume of interest such that a lens system arranged between the laser source and the volume of interest with one or more convex lenses may be optionally. This can reduce the complexity of the assembly of the optical magnetometer. It may also be advantageous for remote measurements of a magnetic field, in particular for remote measurements where an optical system for focusing the emitted optical radiation cannot be feasible arranged between the laser source and the volume of interest to be measured. A remote measurement may be a measurement wherein the distance between the laser source and the volume of interest at which a magnetic field should be measured is 1 m or more, 10 m or more, 100 m or more, or 1 km or more. Remote measurements could for example be used for mining applications. Typical distances for remote measurements may then range between about 1 m and 10 m. For geological remote sensing, typical distances may range from about 100 m to 1 km.

Typical distances for short distance measurements may be more than 1 cm. In particular, the distance may range from about at least 10 cm to about at least 100 cm or more. Short distance measurements could for example be used for medical applications such as e.g. biomedical diagnosis.

According to embodiments described herein, the volume of interest 130 can include a molecular species. For example, the volume of interest 130 can include a molecular species and an atomic species with the atomic species being the atomic constituents of the molecular species. For instance, the volume of interest 130 can include molecular Oxygen $O_2$ and atomic oxygen O. In this example, atomic oxygen O refers to an at least temporarily unbonded oxygen atom. In some embodiments, the volume of interest 130 can include molecular Nitrogen $N_2$ and atomic nitrogen N.

According to embodiments of the present disclosure, the volume of interest 130 is a volume of air. That is to say, the volume of air is volume of a gaseous fluid with the composition of the atmosphere. If the volume of interest 130 is a volume of air, the molecular species can be selected from one of the constituents of the air. In particular, the molecular species can be selected from molecular Nitrogen or molecular Oxygen.

According to embodiments described herein, the laser source 110 is configured to generate a dissociating laser pulse. For instance, the laser source can include one or more laser types selected from the group including a dye laser, a solid state laser, a gas laser, a chemical laser or a semiconductor laser.

The dissociating laser pulse is the same as the pumping laser pulse 112. That is to say, the emitted radiation from the laser source 110 can be used for both, dissociating of the molecular species and pumping of the atomic species, i.e. the atomic constituents of the dissociated molecular species. This has the effect that the same laser source can be used for dissociation and pumping, which could reduce the acquisition costs and size of the magnetometer.

According to embodiments of the present disclosure, the dissociating laser pulse has a laser wavelength tuned for dissociating at least a fraction of the molecular species within the volume of interest to be measured into atomic constituents. That is to say, the laser pulse generated by the laser source provides sufficient high laser pulse energy, e.g. energy per laser pulse, to dissociate the selected molecular species into its atomic components. The laser wavelength of the dissociating laser pulse can be selected in dependency of the energy required to dissociate the selected molecular species. A suitable wavelength may be, for example, generated by frequency mixing of the outputs of two or more lasers having a different output wavelength.

The laser source as described herein can include one or more lasers arranged such that the energy per laser pulse is sufficient to dissociate a molecular species. For example, if the molecular species is oxygen, the laser source may be tuned to generate a dissociating laser pulse having a wavelength of around 226 nm. To stay with this example, the energy per pulse may be then adjusted to around 10 mJ and the pulse duration may be adjusted to around 10 ns.

According to embodiments described herein, the laser source is configured to pump the atomic constituents to an upper electronic state. The upper electronic state of the atomic constituents can be also described as an excited atomic state. In particular, pumping of the atomic constituents can be performed by the pumping laser pulse.

According to embodiments of the present disclosure, the upper electronic state is a state that generates a laserlike emission. The laserlike emission includes a backward propagating beam that is generated upon relaxation of the atomic species from the upper electronic state to a lower electronic state. In particular, the upper electronic state that is associated to air lasing. The laserlike emission can be, for example, an Amplified Spontaneous Emission. The laserlike emission can be substantially coherent, i.e. the coherent proportion of the laserlike emission is greater than the incoherent proportion.

According to embodiments of the present disclosure, the proportion of the laserlike emission that travels in the opposite direction of the pumping laser pulse is greater than the proportion traveling in the same direction of the pumping laser pulse. This could also be described as a backward air lasing beam.

One example of air lasing is the relaxation of atomic oxygen from the $(3p)^3P$ excited state as shown on the left side of Fig. 1. Here, the relaxation to the $(3s)^3S$ state is followed by emission of infrared radiation with a wavelength of about 845nm. Another example of air lasing is the relaxation of atomic nitrogen from the $(3p)^4S^0$ state as shown on the right side of Fig. 1. Here, the relaxation to the $(3s)^4P$ state is followed by the emission of infrared radiation with a wavelength of about 745nm.

Excitation of atomic oxygen or of atomic nitrogen to the upper electronic states associated to air lasing as shown in Fig. 1 can be performed, for example, with a laser emitting ultra-violet radiation. For instance, molecular oxygen can be dissociated with a UV laser of a wavelength of about 226nm into atomic oxygen. The atomic oxygen can be then excited with the same UV laser to the $(3p)^3P$ excited state. Similarly, molecular nitrogen can be dissociated with a UV laser of a wavelength of about 207nm into atomic nitrogen. The atomic nitrogen can be then excited with the same UV laser to the $(3p)^4S^0$ excited state. It is believed that the dissociation and the excitation of molecular oxygen or molecular nitrogen happens by absorptions of two photons at the respective wavelengths discussed above.

Another example of air lasing can be the excitation of oxygen with a picosecond ultraviolet pulse with a wavelength of about 266 nm. Population inversion between the $3p^3P$ and the $3s^3S$ states of oxygen atom can be then achieved by two photon dissociation of the oxygen molecules followed by resonant excitation of the atomic oxygen fragments. Upon relaxation of the excited atomic oxygen fragments, a laserlike emission at a wavelength of about 845 nm is generated.

In a further example, population inversion between the $C^3\Pi_u$ and $B^3\Pi_g$ state of nitrogen molecules is used to generate a backward laserlike emission at a wavelength of about 337 nm. Here, the nitrogen gas is excited (pumped) with a femtosecond pulse at a wavelength of about 800 nm.

Furthermore, it has been found that air lasing is more amplified in the backward direction compared to the forward direction. The backward direction is the direction opposed to the direction of the laser source.

In embodiments of the present disclosure, the laser source can be configured to amplify the optical radiation generated by the atomic species relaxing from the upper electronic state to a lower electronic state by successive optical pumping by the laser source.

According to embodiments of the present disclosure that can be combined with embodiments described herein, the optical magnetometer can include a beam splitter that is configured to separate the pumping laser pulse and the backward propagating beam. In particular, the beam splitter directs the backward propagating to the detector.

Fig. 7 schematically shows an optical magnetometer 200 according to an embodiment of the present disclosure. The optical magnetometer 200 includes similar components than the optical magnetometer 100 shown in Fig. 6, and only the differences will be discussed in the following.

In Fig. 7, an optical system 210 is arranged between the laser source 110 and the volume of interest 130, at which a magnetic field characterizing quantity is to be measured. The optical system 210 includes one or polarizer to polarize the pumping laser pulse 112 emitted from the laser source 110. In the embodiment of Fig. 7, the optical system 210 circularly polarizes the pumping laser pulse 112. In some embodiments, the optical system is configured to elliptically polarize the pumping laser pulse.

A beam splitter 220 is disposed in the path of the pumping laser pulse 112 and the backward propagating beam 114. The beam splitter 220 is configured to transmit radiation at the wavelength of the pumping laser pulse 112 in the forward direction, i.e. from the laser source 110 to the volume of interest 130, and in the backward direction. Radiation at a different wavelength, in particular at the wavelength of the backward radiation 114, is reflected by the beam splitter 220. That is to say, the beam splitter 220 is configured to be translucent for the pumping laser pulse 112 and is further configured to reflect the backward propagating beam 114 generated upon relaxation of the atomic species from the upper electronic state to a lower electronic state. In particular, the beams splitter 220 can be a dichroic mirror.

According to embodiments of the present disclosure, the beams splitter directs the backward propagating beam to the detector. As shown in Fig. 7, the backward propagating beam 114 is reflected from the beam splitter 220 and send to the detector 120.

Embodiments of the present disclosure can further include one or more lenses, such as one or more convex lenses or a combination of one or more convex and concave lenses, for focusing the pumping laser pulse and/or the dissociating laser pulse in the volume of interest to be measured. For example, a convex lens 230 as shown in Fig. 7 can be arranged between the laser source 110 and the volume of interest 130. The convex lens 230 focuses the pumping laser pulse and/or the dissociating laser pulse, i.e. the emitted radiation from the laser source 110, to a focal point within the volume of interest 130.

According to embodiments of the present disclosure which can be combined with embodiments described herein, the light beam characterizing quantity can be a polarization quantity of the detected light beam. The detected light beam is typically the backward propagating beam.

According to embodiments described herein, the detector is configured to detect a polarization of the optical radiation generated by the atomic species after propagation of the optical radiation to the detector.

According to some embodiments, the polarization quantity can be an optical rotation. Accordingly, the detector can be configured to measure an optical rotation. The detector can include components selected from the group including a photomultiplier; a beam splitter, a polarization beam splitter; and a dichroic splitter.

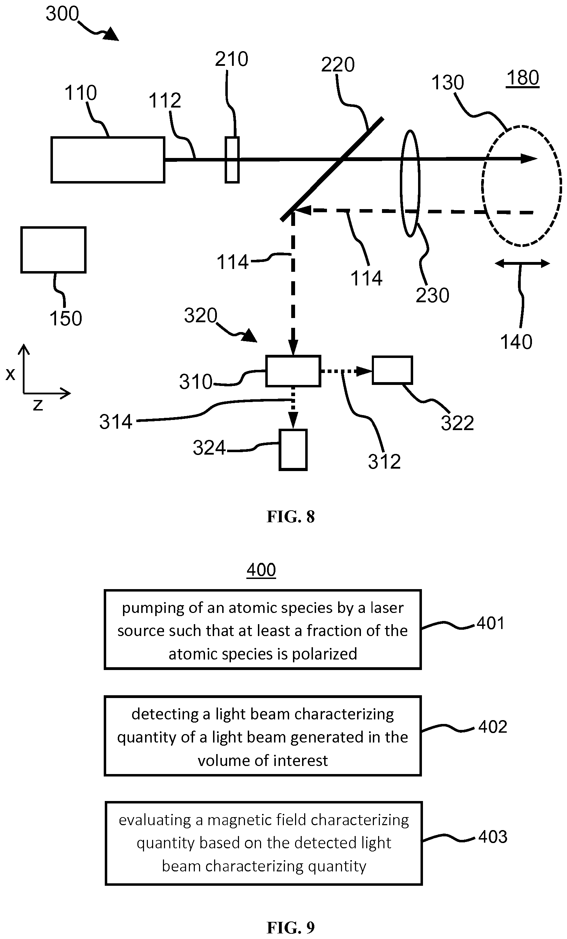

Fig. 8 schematically shows an optical magnetometer 300 according to a further embodiment of the present disclosure. The detector 320 of the optical magnetometer 300 includes a polarization beam splitter 310. The polarization beam splitter 310 separates the polarization into two polarization components. The detector 320 can include a first detecting unit 322 for a first polarization component 312. The detector 320 can further include a second detecting unit 324 for a second polarization component 314.

According to embodiments, the detector can detect a difference in the intensity between the detected first polarization component and the detected second polarization component. The detected intensity difference can be used by the evaluation unit for measuring a polarization rotation.

According to embodiments, the evaluation unit can be configured to derive an optical property of the medium based on the detected light beam characterizing quantity. The optical property can be a complex refractive index.

In some embodiments, the evaluation unit is further configured to deconvolute the signal received from the detector 120 to calculate the magnetic field.

In embodiments of the present disclosure that can be combined with embodiments described herein, the optical property is a magnetic circular dichroism of the medium. In embodiments, the optical property can include a gyrotropic susceptibility of the medium. That is to say, the complex refractive index can be at least one of a circular dichroism and a gyrotropic susceptibility of the medium.

As described above, the light beam characterizing quantity can include information pertaining to a magnetic field characterizing quantity of the magnetic field permeating the volume of interest to be measured.

The magnetic field characterizing quantity can be at least one of a magnetic field strength, a magnetic field direction, a frequency of the magnetic field, and a temporal change of the magnetic field.

According to some embodiments of the present disclosure that can be combined with embodiments described herein, the laser source can be configured to induce filamentation. Filamentation of emitted radiation of the laser source can be, for example, utilized to induce self-focusing of the laser beam. Self-focusing can be induced when the laser source emits a light beam exceeding the self-focusing threshold of the used medium, e.g. of air.

Self-focusing can be described as follows. A lase pulse self focuses until it reaches high enough intensities to ionize the medium in its path. During that course, a narrow column of plasma is left behind. The formation of the plasma causes local defocusing that halts the collapse of the beam as interplay between diffraction, self-focusing, and plasma defocusing ensues. The energy required for continued ionization detracts from the pulse energy so that the self focusing gradually weakens and is eventually overcome by diffraction and plasma defocusing, ultimately terminating the filament. The length of the ionization channel can be on the order of a few centimeters, a few meters, and can extend to hundreds of meters, for example outdoors in outdoor propagation.

In embodiments, the laser source is configured to generate a femtosecond laser pulse. The laser source may be tuned to an oxygen energy level. The oxygen energy level is typically an excited electronic state of an oxygen atom, such as the $(3p)^3P$ state of atomic oxygen.

In embodiments, the laser may be tuned to a nitrogen energy level. The nitrogen energy level is typically an excited electronic state of an nitrogen atom, such as the $(3p)^4S^0$ state of atomic nitrogen.

The laser source may include at least one UV laser emitting light at a ultraviolet wavelength. More particularly, the ultra-violet wavelength can include wavelengths of about 226 nm or wavelengths of about 207nm. The UV laser can be used to dissociate molecular oxygen or to dissociate molecular nitrogen. The power output of the UV laser beam is typically sufficient high enough to provide dissociation of the selected molecular species.

According to embodiments of the present disclosure, which can be combined with embodiments described herein, a beam multiplier can be arranged between the laser source and the volume of interest to be measured. The beam multiplier is typically configured to split the dissociating laser pulse and/or the pumping laser pulse into a plurality of spatially separate laser beams.

Fig. 9 is a chart illustrating a method 400 of determining a magnetic field according to embodiments described herein. At box 401, pumping the atomic species by a laser source directed to the volume of interest to an upper electronic state such that at least a fraction of the atomic species is polarized is performed. A light beam characterizing quantity of the light beam passing the optical path within the volume of interest is detected at box 402. The light beam is generated upon relaxation of the upper electronic state to a lower electronic state of the atomic species in the volume of interest. A magnetic field characterizing quantity of the magnetic field permeating the volume of interest based on the detected light beam characterizing quantity is evaluated at box 403.

According to some embodiments of the present disclosure that can be combined with embodiments described herein, the method can further include generating the atomic species by a dissociating laser pulse by the laser source. In embodiments, the method can include dissociating with the dissociating laser pulse the molecular species within the volume of interest into atomic constituents as the atomic species. Dissociation is performed with the pumping laser pulse.

According to some embodiments of the present disclosure that can be combined with embodiments described herein, detecting the light beam characterizing quantity can further include detecting a backward propagating light beam generated by the atomic species relaxing from the upper electronic state to a lower electronic state.

The optical magnetometer according to the embodiments described herein can be used in a variety of fields. For example, the optical magnetometer could be used for the detection of biomagnetic fields. This can include biological research applications or medical applications such as magnetocardiography or magnetoencephalography.

Optical magnetometers according to the embodiments described herein could be utilized for geophysical applications, e.g. for airborne, ground, or marine applications. For example, the optical magnetometer could be used for earthquake studies. Further, the optical magnetometer could be used for exploration of geological formations, for example for mining.

While the foregoing is directed to embodiments of the disclosure, other and further embodiments of the disclosure may be devised without departing from the basic scope thereof, and the scope thereof is determined by the claims that follow.

**Claims**

1. An optical magnetometer (100) for determining a magnetic field permeating a volume of interest (130), wherein the volume of interest comprises a medium including a molecular species, wherein the magnetic field is determined by detecting a light beam (112, 114) passing an optical path (140) within the volume of interest, the optical magnetometer comprising:

   a laser source (110) directed to the volume of interest (130), wherein
   the laser source (110) is configured to generate a pumping laser pulse being also a dissociating laser pulse, wherein the optical magnetometer is configured to generate an atomic species by the dissociating laser pulse, wherein the dissociating laser pulse has a laser wavelength tuned for dissociating at least a fraction of the molecular species within the volume of interest (130) into atomic constituents as the atomic species, the pumping laser pulse having a wavelength tuned for pumping the atomic species to an upper electronic state, such that the pumping laser pulse is configured to simultaneously dissociate the molecular species and excite one of the atomic constituents, this excitation being followed by lasing from the excited atomic state via stimulated Raman scattering, wherein
   the pumping laser pulse is configured to polarize at least a fraction of the atomic species;
   a detector (120) configured to detect a light beam characterizing quantity of the light beam (112, 114) passing the optical path (140) within the volume of interest, wherein the light beam is generated upon relaxation of the upper electronic state to a lower electronic state of the atomic species in the volume of interest; and
   an evaluation unit (150) configured to evaluate a magnetic field characterizing quantity of the magnetic field permeating the volume of interest (130) based on the detected light beam characterizing quantity detected by the detector (120).

2. The optical magnetometer (100) according to any one of the preceding claims, wherein the light beam characterizing quantity is an intensity of the detected light beam.

3. The optical magnetometer (100) according to any of one of the preceding claims, wherein the upper electronic state is a state that generates a laserlike emission, wherein a backward propagating beam is generated upon relaxation of the atomic species from the upper electronic state to a lower electronic state,
   the optical magnetometer (100) preferably further comprising a beam splitter (220) configured to separate the pumping laser pulse and the backward propagating beam, wherein the beam splitter directs the backward propagating to the detector.

4. The optical magnetometer (100) according to any one of the preceding claims, with at least one of the following:

   (a) the optical magnetometer (100) further comprising an optical system (210) arranged between the laser source and the volume of interest, wherein the optical system (210) is configured to polarize the beam emitted from the laser source (110) into a polarized beam;
   (b) the light beam characterizing quantity is a polarization quantity of the detected light beam, wherein the polarization quantity is preferably an optical rotation;
   (c) the detector (120) is configured to detect a polarization of the optical radiation generated by the atomic species after propagation of the optical radiation to the detector;
   (d) the detector (210) is configured to separate the polarization components of the received optical radiation; and/or
   (e) the detector (210) includes a polarization beam splitter (310) configured to separate the backward propagating beam into individual polarization components (312, 314), the detector (120) being further configured to detect the individual polarization components.

5. The optical magnetometer (100) according to any one of the preceding claims, wherein the evaluation unit (150) is configured to derive an optical property of the medium based on the detected light beam characterizing quantity, wherein the optical property is a complex refractive index, wherein preferably at least one of (a) and (b):

(a) the optical property is a magnetic circular dichroism of the medium;
(b) the optical property is a gyrotropic susceptibility of the medium.

6. The optical magnetometer (100) according to any one of the preceding claims, wherein the magnetic field characterizing quantity is at least one of a magnetic field strength, a magnetic field direction, a frequency of the magnetic field, and a temporal change of the magnetic field.

7. The optical magnetometer (100) of any one of the preceding claims, wherein the laser source is configured to induce filamentation.

8. The optical magnetometer (100) to any one of the preceding claims, wherein the evaluation unit (150) is configured to deconvolute the signal received from the detector (120) to calculate the magnetic field.

9. The optical magnetometer (100) according to any one of the preceding claims, wherein the laser source (110) is configured to generate a femtosecond laser pulse.

10. The optical magnetometer (100) according to any one of the preceding claims, wherein the molecular species is selected from the group consisting of molecular oxygen and molecular nitrogen, wherein preferably at least one of (a) and (b):

(a) the dissociating and pumping laser pulse is tuned to an oxygen energy level or a nitrogen energy level;
(b) the dissociating laser pulse is configured to dissociate the molecular oxygen by two-photon absorption at a wavelength of 226 nm or configured to dissociate the molecular nitrogen by two-photon absorption at a wavelength of 207 nm.

11. The optical magnetometer (100) according to any one of the preceding claims, wherein (a) and/or (b):

(a) the detector (120) includes components selected from the group comprising: a photomultiplier; a beam splitter, a polarization beam splitter; and a dichroic splitter;
(b) a beam multiplier is arranged between the laser source and the volume of interest (130), the beam multiplier being configured to split the dissociating laser pulse and the pumping laser pulse into a plurality of spatially separate laser beams.

12. The optical magnetometer (100) to any one of the preceding claims, wherein the laser source (110) is configured to amplify an optical radiation generated by the atomic species relaxing from the upper electronic state to a lower electronic state by successive optical pumping by the laser source (110).

13. A method (400) of determining a magnetic field permeating a volume of interest (130), wherein the volume of interest comprises a medium including a molecular species, wherein the magnetic field is determined by detecting a light beam passing an optical path within the volume of interest, the method comprises:
generating an atomic species by a dissociating laser pulse by the laser source, the dissociating laser pulse dissociating at least a fraction of the molecular species within the volume of interest (130) into atomic constituents as the atomic species; and

pumping the atomic species by the laser source (110) directed to the volume of interest to an upper electronic state such that at least a fraction of the atomic species is polarized, whereby
the laser pulse simultaneously dissociates the molecular species and excites one of the atomic constituents, this excitation being followed by lasing from the excited atomic state via stimulated Raman scattering;
detecting a light beam characterizing quantity of the light beam passing the optical path within the volume of interest (130), wherein the light beam is generated upon relaxation of the upper electronic state to a lower electronic state of the atomic species in the volume of interest; and
evaluating a magnetic field characterizing quantity of the magnetic field permeating the volume of interest based on the detected light beam characterizing quantity.

**14.** The method of measuring a magnetic field according to claim 13, wherein detecting the light beam characterizing quantity comprises detecting a backward propagating light beam generated by the atomic species relaxing from the upper electronic state to a lower electronic state.

**Patentansprüche**

**1.** Optisches Magnetometer (100) zum Bestimmen eines Magnetfeldes, das ein Volumen von Interesse (130) durchdringt, wobei das Volumen von Interesse ein Medium umfasst, das eine molekulare Spezies enthält, wobei das Magnetfeld durch Erfassen eines Lichtstrahls (112, 114) bestimmt wird, der einen optischen Pfad (140) innerhalb des Volumens von Interesse passiert, wobei das optische Magnetometer umfasst:

eine Laserquelle (110), die auf das Volumen von Interesse (130) gerichtet ist, wobei
die Laserquelle (110) derart konfiguriert ist, dass sie einen Pumplaserpuls erzeugt, der auch ein Dissoziationslaserpuls ist,
wobei das optische Magnetometer derart konfiguriert ist, dass es eine atomare Spezies durch den Dissoziationslaserpuls erzeugt, wobei der Dissoziationslaserpuls eine Laserwellenlänge aufweist, die so abgestimmt ist, dass zumindest ein Teil der molekularen Spezies innerhalb des Volumens von Interesse (130) in atomare Bestandteile als die atomare Spezies dissoziiert wird,
der Pumplaserpuls eine Wellenlänge aufweist, die zum Pumpen der atomaren Spezies in einen oberen elektronischen Zustand abgestimmt ist,
so dass der Pumplaserpuls derart konfiguriert ist, dass er gleichzeitig die molekulare Spezies dissoziiert und einen der atomaren Bestandteile anregt, wobei auf diese Anregung ein Lasern aus dem angeregten atomaren Zustand mittels stimulierter Raman-Streuung folgt, wobei
der Pumplaserpuls derart konfiguriert ist, dass er zumindest einen Teil der atomaren Spezies polarisiert;
einen Detektor (120), der derart konfiguriert ist, dass er eine den Lichtstrahl charakterisierende Größe des Lichtstrahls (112, 114) erfasst, der den optischen Pfad (140) innerhalb des Volumens von Interesse durchläuft, wobei der Lichtstrahl bei der Relaxation des oberen elektronischen Zustands zu einem unteren elektronischen Zustand der atomaren Spezies in dem Volumen von Interesse erzeugt wird; und
eine Auswerteeinheit (150), die derart konfiguriert ist, dass sie eine das Magnetfeld charakterisierende Größe des das Volumen von Interesse (130) durchdringenden Magnetfeldes basierend auf der vom Detektor (120) erfassten, den Lichtstrahl charakterisierenden Größe auswertet.

**2.** Optisches Magnetometer (100) nach einem der vorhergehenden Ansprüche, wobei die den Lichtstrahl charakterisierende Größe eine Intensität des erfassten Lichtstrahls ist.

**3.** Optisches Magnetometer (100) nach einem der vorhergehenden Ansprüche, wobei der obere elektronische Zustand ein Zustand ist, der eine laserartige Emission erzeugt, wobei ein sich rückwärts ausbreitender Strahl bei der Relaxation der atomaren Spezies von dem oberen elektronischen Zustand zu einem unteren elektronischen Zustand erzeugt wird,
wobei das optische Magnetometer (100) vorzugsweise ferner einen Strahlteiler (220) umfasst, der derart konfiguriert ist, dass er den Pumplaserpuls und den sich rückwärts ausbreitenden Strahl trennt, wobei der Strahlteiler den sich rückwärts ausbreitenden Strahl auf den Detektor lenkt.

**4.** Optisches Magnetometer (100) nach einem der vorhergehenden Ansprüche, mit mindestens einem von Folgendem:

(a) das optische Magnetometer (100) ferner ein optisches System (210) umfassend, das zwischen der Laserquelle und dem Volumen von Interesse angeordnet ist, wobei das optische System (210) derart konfiguriert ist, dass es den von der Laserquelle (110) emittierten Strahl in einen polarisierten Strahl polarisiert;
(b) die den Lichtstrahl charakterisierende Größe eine Polarisationsgröße des detektierten Lichtstrahls ist, wobei die Polarisationsgröße vorzugsweise eine optische Drehung ist;
(c) der Detektor (120) derart konfiguriert ist, dass er eine Polarisation der von der atomaren Spezies erzeugten optischen Strahlung nach der Ausbreitung der optischen Strahlung zum Detektor erfasst;
(d) der Detektor (210) konfiguriert ist, die Polarisationskomponenten der empfangenen optischen Strahlung zu trennen; und/oder
(e) der Detektor (210) einen Polarisationsstrahlteiler (310) aufweist, der derart konfiguriert ist, dass er den sich rückwärts ausbreitenden Strahl in einzelne Polarisationskomponenten (312, 314) trennt, wobei der Detektor (120) ferner konfiguriert ist, um die einzelnen Polarisationskomponenten zu erfassen.

**5.** Optisches Magnetometer (100) nach einem der vorhergehenden Ansprüche, wobei die Auswerteeinheit (150) derart konfiguriert ist, dass sie basierend auf der detektierten, den Lichtstrahl charakterisierenden Größe eine optische Eigenschaft des Mediums ableitet, wobei die optische Eigenschaft ein komplexer Brechungsindex ist, wobei vorzugsweise mindestens eines von (a) und (b) gilt:

(a) die optische Eigenschaft ist ein magnetischer Zirkulardichroismus des Mediums;
(b) die optische Eigenschaft ist eine gyrotrope Suszeptibilität des Mediums.

**6.** Optisches Magnetometer (100) nach einem der vorhergehenden Ansprüche, wobei die das Magnetfeld charakterisierende Größe mindestens eines von einer Magnetfeldstärke, einer Magnetfeldrichtung, einer Frequenz des Magnetfeldes und einer zeitlichen Änderung des Magnetfeldes ist.

**7.** Optisches Magnetometer (100) nach einem der vorhergehenden Ansprüche, wobei die Laserquelle derart konfiguriert ist, dass sie eine Filamentierung induziert.

**8.** Optisches Magnetometer (100) nach einem der vorangehenden Ansprüche, wobei die Auswerteeinheit (150) derart konfiguriert ist, dass sie das von dem Detektor (120) erhaltene Signal dekonvolutiert, um das Magnetfeld zu berechnen.

**9.** Optisches Magnetometer (100) nach einem der vorangehenden Ansprüche, wobei die Laserquelle (110) derart konfiguriert ist, dass sie einen Femtosekunden-Laserpuls erzeugt.

**10.** Optisches Magnetometer (100) nach einem der vorhergehenden Ansprüche, wobei die molekulare Spezies aus der Gruppe ausgewählt ist, die aus molekularem Sauerstoff und molekularem Stickstoff besteht, wobei vorzugsweise mindestens eines von (a) und (b) gilt:

(a) der Dissoziations- und Pumplaserpuls ist auf ein Sauerstoff-Energieniveau oder ein Stickstoff-Energieniveau abgestimmt;
(b) der Dissoziationslaserpuls ist derart konfiguriert, dass er den molekularen Sauerstoff durch Zwei-Photonen-Absorption bei einer Wellenlänge von 226 nm dissoziiert, oder derart konfiguriert, dass er den molekularen Stickstoff durch Zwei-Photonen-Absorption bei einer Wellenlänge von 207 nm dissoziiert.

**11.** Optisches Magnetometer (100) nach einem der vorhergehenden Ansprüche, wobei (a) und/oder (b) gilt:

(a) der Detektor (120) Komponenten aufweist, die aus der Gruppe ausgewählt sind, die umfasst: einen Photomultiplier; einen Strahlteiler, einen Polarisationsstrahlteiler; und einen dichroitischen Teiler;
(b) ein Strahlvervielfacher zwischen der Laserquelle und dem Volumen von Interesse (130) angeordnet ist, wobei der Strahlvervielfacher derart konfiguriert ist, dass er den Dissoziationslaserpuls und den Pumplaserpuls in eine Vielzahl von räumlich getrennten Laserstrahlen teilt.

**12.** Optisches Magnetometer (100) nach einem der vorhergehenden Ansprüche, wobei die Laserquelle (110) derart konfiguriert ist, dass sie eine optische Strahlung verstärkt, die von der atomaren Spezies erzeugt wird, die durch sukzessives optisches Pumpen durch die Laserquelle (110) von dem oberen elektronischen Zustand in einen unteren elektronischen Zustand relaxiert.

**13.** Verfahren (400) zum Bestimmen eines Magnetfeldes, das ein Volumen von Interesse (130) durchdringt, wobei das Volumen von Interesse ein Medium umfasst, das eine molekulare Spezies enthält, wobei das Magnetfeld durch Erfassen eines Lichtstrahls bestimmt wird, der einen optischen Pfad innerhalb des Volumens von Interesse passiert, wobei das Verfahren umfasst:
Erzeugen einer atomaren Spezies durch einen Dissoziationslaserpuls durch die Laserquelle, wobei der Dissoziationslaserpuls mindestens einen Bruchteil der molekularen Spezies innerhalb des Volumens von Interesse (130) in atomare Bestandteile als die atomare Spezies dissoziiert; und

Pumpen der atomaren Spezies durch die Laserquelle (110), die auf das Volumen von Interesse gerichtet ist, auf einen oberen elektronischen Zustand, so dass mindestens ein Bruchteil der atomaren Spezies polarisiert ist, wodurch
der Laserpuls gleichzeitig die molekulare Spezies dissoziiert und einen der atomaren Bestandteile anregt, wobei auf diese Anregung ein Lasern aus dem angeregten atomaren Zustand mittels stimulierter Raman-Streuung folgt;

Erfassen einer den Lichtstrahl charakterisierenden Größe des Lichtstrahls, der den optischen Pfad innerhalb des Volumens von Interesse (130) durchläuft, wobei der Lichtstrahl bei Relaxation des oberen elektronischen Zustands zu einem unteren elektronischen Zustand der atomaren Spezies in dem Volumen von Interesse erzeugt wird; und

Auswerten einer das Magnetfeld charakterisierenden Größe des Magnetfeldes, das das Volumen von Interesse durchdringt, basierend auf der detektierten, den Lichtstrahl charakterisierenden Größe.

14. Verfahren zum Messen eines Magnetfelds nach Anspruch 13, wobei das Erfassen der den Lichtstrahl charakterisierenden Größe das Erfassen eines sich rückwärts ausbreitenden Lichtstrahls umfasst, der von der atomaren Spezies erzeugt wird, die von dem oberen elektronischen Zustand zu einem unteren elektronischen Zustand relaxiert.

**Revendications**

1. Magnétomètre optique (100) pour déterminer un champ magnétique passant à travers un volume d'intérêt (130), dans lequel le volume d'intérêt comprend un médium incluant une espèce moléculaire, dans lequel le champ magnétique est déterminé par détection d'un faisceau de lumière (112, 114) passant sur une trajectoire optique (140) à l'intérieur du volume d'intérêt, le magnétomètre optique comprenant :

une source laser (110) dirigée vers le volume d'intérêt (130), dans lequel

la source laser (110) est configurée pour générer une impulsion laser de pompage qui est également une impulsion laser de dissociation,

dans lequel le magnétomètre optique est configuré pour générer une espèce atomique par l'impulsion laser de dissociation,

dans lequel l'impulsion laser de dissociation a une longueur d'onde laser accordée pour dissocier au moins une fraction de l'espèce moléculaire à l'intérieur du volume d'intérêt (130) en constituants atomiques comme espèce atomique,

l'impulsion laser de pompage ayant une longueur d'onde accordée pour pomper l'espèce atomique à un état électronique supérieur,

de telle sorte que l'impulsion laser de pompage soit configurée pour dissocier simultanément l'espèce moléculaire et exciter l'un des constituants atomiques, cette excitation étant suivie par une émission laser depuis l'état atomique excité via une diffusion Raman stimulée, dans lequel

l'impulsion laser de pompage est configurée pour polariser au moins une fraction de l'espèce atomique ;

un détecteur (120) configuré pour détecter une quantité caractérisante de faisceau de lumière du faisceau de lumière (112, 114) passant sur la trajectoire optique (140) à l'intérieur du volume d'intérêt, dans lequel le faisceau de lumière est généré lors de la relaxation de l'état électronique supérieur à un état électronique inférieur de l'espèce atomique dans le volume d'intérêt ; et

une unité d'évaluation (150) configurée pour évaluer une quantité caractérisante de champ magnétique du champ magnétique passant à travers le volume d'intérêt (130) sur la base de la quantité caractérisante de faisceau de lumière détectée détectée par le détecteur (120).

2. Magnétomètre optique (100) selon l'une quelconque des revendications précédentes, dans lequel la quantité caractérisante de faisceau de lumière est une intensité du faisceau de lumière détecté.

3. Magnétomètre optique (100) selon l'une quelconque des revendications précédentes, dans lequel l'état électronique supérieur est un état qui génère une émission de type laser, dans lequel un faisceau à propagation arrière est généré lors de la relaxation de l'espèce atomique de l'état électronique supérieur à un état électronique inférieur, le magnétomètre optique (100) comprenant de préférence en outre un séparateur de faisceau (220) configuré pour séparer l'impulsion laser de pompage et le faisceau à propagation arrière, dans lequel le séparateur de faisceau dirige la propagation arrière vers le détecteur.

4. Magnétomètre optique (100) selon l'une quelconque des revendications précédentes, avec l'un au moins des éléments suivants :

(a) le magnétomètre optique (100) comprenant en outre un système optique (210) agencé entre la source laser et le volume d'intérêt, dans lequel le système optique (210) est configuré pour polariser le faisceau émis depuis la source laser (110) en un faisceau polarisé ;

EP 3 717 920 B1

(b) la quantité caractérisante de faisceau de lumière est une quantité de polarisation du faisceau de lumière détecté, dans lequel la quantité de polarisation est de préférence une rotation optique ;

(c) le détecteur (120) est configuré pour détecter une polarisation du rayonnement optique généré par l'espèce atomique après propagation du rayonnement optique vers le détecteur ;

(d) le détecteur (210) est configuré pour séparer les composantes de polarisation du rayonnement optique reçu ; et/ou

(e) le détecteur (210) inclut un séparateur de faisceau de polarisation (310) configuré pour séparer le faisceau à propagation arrière en composantes de polarisation individuelles (312, 314), le détecteur (120) étant en outre configuré pour détecter les composantes de polarisation individuelles.

5. Magnétomètre optique (100) selon l'une quelconque des revendications précédentes, dans lequel l'unité d'évaluation (150) est configurée pour obtenir une propriété optique du médium sur la base de la quantité caractérisante de faisceau de lumière détectée, dans lequel la propriété optique est un indice de réfraction complexe, dans lequel de préférence l'un au moins de (a) et (b) :

(a) la propriété optique est un dichroïsme circulaire magnétique du médium ;
(b) la propriété optique est une susceptibilité gyrotropique du médium.

6. Magnétomètre optique (100) selon l'une quelconque des revendications précédentes, dans lequel la quantité caractérisante de champ magnétique est l'une au moins parmi une intensité de champ magnétique, une direction de champ magnétique, une fréquence du champ magnétique et un changement temporel du champ magnétique.

7. Magnétomètre optique (100) selon l'une quelconque des revendications précédentes, dans lequel la source laser est configurée pour induire une filamentation.

8. Magnétomètre optique (100) selon l'une quelconque des revendications précédentes, dans lequel l'unité d'évaluation (150) est configurée pour déconvolutionner le signal reçu du détecteur (120) pour calculer le champ magnétique.

9. Magnétomètre optique (100) selon l'une quelconque des revendications précédentes, dans lequel la source laser (110) est configurée pour générer une impulsion laser femtoseconde.

10. Magnétomètre optique (100) selon l'une quelconque des revendications précédentes, dans lequel l'espèce moléculaire est sélectionnée parmi le groupe consistant en oxygène moléculaire et azote moléculaire, dans lequel de préférence l'un au moins de (a) et (b) :

(a) l'impulsion laser de dissociation et de pompage est accordée à un niveau d'énergie d'oxygène ou un niveau d'énergie d'azote ;
(b) l'impulsion laser de dissociation est configurée pour dissocier l'oxygène moléculaire par absorption à deux photons à une longueur d'onde de 226 nm ou configurée pour dissocier l'azote moléculaire par absorption à deux photons à une longueur d'onde de 207 nm.

11. Magnétomètre optique (100) selon l'une quelconque des revendications précédentes, dans lequel (a) et/ou (b) :

(a) le détecteur (120) inclut des composants sélectionnés parmi le groupe comprenant : un photomultiplicateur ; un séparateur de faisceau, un séparateur de faisceau de polarisation ; et un séparateur dichroïque ;
(b) un multiplicateur de faisceau est agencé entre la source laser et le volume d'intérêt (130), le multiplicateur de faisceau étant configuré pour diviser l'impulsion laser de dissociation et l'impulsion laser de pompage en une pluralité de faisceaux laser séparés spatialement.

12. Magnétomètre optique (100) selon l'une quelconque des revendications précédentes, dans lequel la source laser (110) est configurée pour amplifier un rayonnement optique généré par l'espèce atomique se relaxant de l'état électronique supérieur à un état électronique inférieur par pompage optique successif par la source laser (110).

13. Procédé (400) de détermination d'un champ magnétique passant à travers un volume d'intérêt (130), dans lequel le volume d'intérêt comprend un médium incluant une espèce moléculaire, dans lequel le champ magnétique est déterminé par détection d'un faisceau de lumière passant sur une trajectoire optique à l'intérieur du volume d'intérêt, le procédé comprend :

générer une espèce atomique par une impulsion laser de dissociation par la source laser, l'impulsion laser de dissociation dissociant au moins une fraction de l'espèce moléculaire à l'intérieur du volume d'intérêt (130) en constituants atomiques comme espèce atomique ; et

pomper l'espèce atomique par la source laser (110) dirigée vers le volume d'intérêt à un état électronique supérieur de telle sorte qu'au moins une fraction de l'espèce atomique soit polarisée, moyennant quoi l'impulsion laser dissocie simultanément l'espèce moléculaire et excite l'un des constituants atomiques, cette excitation étant suivie par une émission laser depuis l'état atomique excité via une diffusion de Raman stimulée ; détecter une quantité caractérisante de faisceau de lumière du faisceau de lumière passant sur la trajectoire optique à l'intérieur du volume d'intérêt (130), dans lequel le faisceau de lumière est généré lors de la relaxation de l'état électronique supérieur à un état électronique inférieur de l'espèce atomique dans le volume d'intérêt ; et évaluer une quantité caractérisante de champ magnétique du champ magnétique passant à travers le volume d'intérêt sur la base de la quantité caractérisante de faisceau de lumière détectée.

14. Procédé de mesure d'un champ magnétique selon la revendication 13, dans lequel détecter la quantité caractérisante de faisceau de lumière comprend détecter un faisceau de lumière à propagation arrière généré par l'espèce atomique se relaxant de l'état électronique supérieur à un état électronique inférieur.

**FIG. 1**

**FIG. 2**

**FIG. 3**

**FIG. 4**

**FIG. 5**

**FIG. 6**

**FIG. 7**

300

110 112 210 220 130 180

150

x
z

320
310
314
324 312
322

**FIG. 8**

400

| pumping of an atomic species by a laser source such that at least a fraction of the atomic species is polarized | 401 |

| detecting a light beam characterizing quantity of a light beam generated in the volume of interest | 402 |

| evaluating a magnetic field characterizing quantity based on the detected light beam characterizing quantity | 403 |

**FIG. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **JAMES M. HIGBIE et al.** Magnetometry with mesospheric sodium. *PROCEEDINGS OF THE NATIONAL ACADEMY OF SCIENCES OF THE UNITED STATES OF AMERICA,* 01 March 2011, vol. 108 (9), 3522-3525

- **ALEXANDRE LAURAIN et al.** Low-Threshold Bidirectionat Air Lasing. *PHYSICAL REVIEW LETTERS,* 17 December 2014, vol. 113 (25